(19) Europäisches Patentamt
European Patent Office
Office européen des brevets

(11) **EP 1 628 340 B1**

(12) **EUROPÄISCHE PATENTSCHRIFT**

(45) Veröffentlichungstag und Bekanntmachung des Hinweises auf die Patenterteilung:
**25.03.2009 Patentblatt 2009/13**

(51) Int Cl.:
*H01L 21/8222* (2006.01)    *H01L 27/082* (2006.01)
*H01L 27/06* (2006.01)

(21) Anmeldenummer: **05016050.6**

(22) Anmeldetag: **23.07.2005**

(54) **Verfahren zur Integration von drei Bipolartransistoren in einen Halbleiterkörper, Mehrschichtbauelement und Halbleiteranordnung**

Method of integrating three bipolar transistors in a semiconductor body, multilayer device and semiconductor apparatus

Méthode d'intégration des trois transistors bipolaires dans un corps semiconducteur, dispositif multi-couches et dispositif semiconducteur

(84) Benannte Vertragsstaaten:
**DE FR**

(30) Priorität: **31.07.2004 DE 102004037252**

(43) Veröffentlichungstag der Anmeldung:
**22.02.2006 Patentblatt 2006/08**

(73) Patentinhaber: **ATMEL Germany GmbH
74072 Heilbronn (DE)**

(72) Erfinder: **Bromberger, Christoph, Dipl.-Phys.
74074 Heilbronn (DE)**

(74) Vertreter: **Müller, Wolf-Christian
Patentanwalt
Maaßstraße 32/1
69123 Heidelberg (DE)**

(56) Entgegenhaltungen:
EP-A- 0 605 920        WO-A-20/05020330
DE-A1- 3 743 774       US-A- 4 771 013

• GILBERT B: "A PRECISE FOUR-QUADRANT MULTIPLIER WITH SUBNANOSECOND RESPONSE" IEEE JOURNAL OF SOLID-STATE CIRCUITS, IEEE INC. NEW YORK, US, Bd. SC-3, Nr. 4, 1. Dezember 1968 (1968-12-01), Seiten 365-373, XP000563293 ISSN: 0018-9200

## Beschreibung

Die vorliegende Erfindung betrifft ein Verfahren zur Integration von drei Bipolartransistoren in einen Halbleiterkörper, ein Mehrschichtbauelement und eine Halbleiteranordnung.

Aus der Druckschrift EP 0 493 854, nachfolgend als D1 bezeichnet, sind vertikal integrierte Kaskodenstrukturen mit lediglich zwei Transistoren für Hochvoltanwendungen bekannt. Hierbei wird ein geometrisch untenliegender Transistor mit einer hohen Sperrfähigkeit mit einem geometrisch obenliegenden Transistor vertikal integriert. Derartige Anordnungen werden vorzugsweise im Spannungsbereich über 100 V eingesetzt. Die Emitterregion des geometrisch untenliegenden Transistors weist, bei demselben Leitungstyp, eine deutlich höhere Dotierstoffkonzentration auf als eine angrenzende Kollektor-Driftzone des geometrisch obenliegenden Transistors. Hierdurch wird insbesondere die Emitter-Effektivität des geometrisch untenliegenden Transistors erhöht. Die vertikale Integration beispielsweise zweier npn-Transistoren ergibt einen parasitären pnp-Transistor, so dass die Anordnung aus D1 zu thyristorähnlichem Verhalten neigt und der Kollektorstrom nur eingeschränkt steuerfähig bleibt.

In der Druckschrift EP 605920, nachfolgend als D2 bezeichnet, wird die Neigung der Anordnung aus D1 zu thyristorähnlichem Verhalten über eine Erhöhung der Gummelzahl $G_B$ des parasitären Transistors verringert. Hierzu wird die Emitterregion des unteren Transistors als hochdotierte Schicht ausgeführt, die die Basis des unteren Transistors von der Kollektor-Driftzone des oberen Transistors durchgehend voneinander trennt, indem eine MESA (Tafelberg)-Struktur erzeugt wird. In der D2 sind ausschließlich zwei Transistoren in die MESA (Tafelberg)-Struktur integrierbar. In einer weiteren Ausführungsform wird in D2 p-dotiertes SiGe als Ätzstopp für die Herstellung der MESA-Struktur in der Basis des unteren Transistors verwendet.

Aus der US 4,771,013 ist ein dreidimensionaler Bipolar-Wafer-Prozess zur Integration von Hochvolt-, Hochleistungs- Analog- und Digitalschaltkreisen bekannt, wobei durch Ätzung dreidimensionale Transistoren ausgebildet werden. Die DE 3743774 A1 betrifft Bipolartransistoren und Dioden, die übereinander angeordnet sind. Die Bauelementschichten und die entsprechenden Kontaktschichten werden in einem Epitaxie-Verfahren hergestellt.

Aufgabe der vorliegenden Erfindung ist es, ein Verfahren zur Integration mehrerer Bipolartransistoren anzugeben deren elektrische Eigenschaften möglichst verbessert sind. Eine weitere Aufgabe der Erfindung besteht darin, Anordnungen von Bipolartransistoren in Halbleiterkörpern und Mehrschichtbauelemente aufzuzeigen. Die erstgenannte Aufgabe wird durch die Merkmale des Anspruchs 1, die zweitgenannte Aufgabe wird durch die Merkmale des Anspruches 10 oder des Anspruchs 17 gelöst. Günstige Weiterbildungen und Ausgestaltungsformen sind jeweils Gegenstand von Unteransprüchen.

Demzufolge ist erfindungsgemäß ein Verfahren zur Integration von drei Bipolartransistoren in einen Halbleiterkörper vorgesehen, indem eine erste schichtförmige Halbleiterregion eines ersten Leitungstyps erzeugt wird. Zudem wird eine zweite schichtförmige Halbleiterregion eines zweiten, dem ersten Leitungstyp entgegengesetzten Leitungstyps erzeugt, die an die erste Halbleiterregion grenzt. Es wird eine dritte schichtförmige Halbleiterregion des ersten Leitungstyps erzeugt, die an die zweite Halbleiterregion grenzt. Eine vierte schichtförmige Halbleiterregion und eine fünfte schichtförmige Halbleiterregion des zweiten Leitungstyps werden erzeugt, die an die dritte Halbleiterregion grenzen. Die zweite schichtförmige Halbleiterregion, die vierte schichtförmige Halbleiterregion und die fünfte schichtförmige Halbleiterregion bilden die Basen der drei Bipolartransistoren.

Weiterhin werden eine sechste und eine siebte schichtförmige Halbleiterregion des ersten Leitungstyps erzeugt, wobei die sechste Halbleiterregion an die vierte Halbleiterregion und die siebte Halbleiterregion an die fünfte Halbleiterregion grenzt. Die zweite Halbleiterregion und/oder die vierte Halbleiterregion und/oder die fünfte Halbleiterregion wird aus einem ersten Halbleitermaterial hergestellt, während die dritte Halbleiterregion aus einem zweiten Halbleitermaterial hergestellt wird. Dabei werden das erste Halbleitermaterial und das zweite Halbleitermaterial derart hergestellt, dass der Wert der Energielücke in dem ersten Halbleitermaterial um mindestens die mittlere thermische Energie der Ladungsträger kleiner ist, als der Wert der Energielücke in dem zweiten Halbleitermaterial.

Es wird ein Schaltungsteil aus zumindest drei Transistoren derart integriert, dass zumindest zwei Emitter und zumindest ein Kollektor der Transistoren oder zumindest zwei Kollektoren und zumindest ein Emitter der Transistoren eine gemeinsame Halbleiterregion bilden, wobei thyristorähnliches Verhalten eines oder mehrerer parasitärer Transistoren reduziert ist.

Durch die Integration kann eine neuartige, vorzugsweise vertikal integrierte, verzweigte Kaskodenstruktur erzeugt werden. Beispielsweise ist der erste Leitungstyp der n-Leitungstyp und der zweite Leitungstyp der p-Leitungstyp. Durch die erste, die zweite und die dritte Halbleiterregion wird in diesem Ausführungsbeispiel ein erster npn-Transistor gebildet, wobei ein Emitter des ersten npn-Transistors durch die dritte, und eine Basis durch die zweite Halbleiterregion gebildet werden. Ein zweiter npn-Transistor wird durch die dritte Halbleiterregion, die vierte und die sechste Halbleiterregion gebildet. Ein dritter npn-Transistor wird durch die dritte Halbleiterregion und durch die fünfte und siebte Halbleiterregion gebildet. Neben den gewünschten npn-Transistoren bilden sich parasitäre pnp-Transistoren aus. Ein parasitärer pnp-Transistor wird beispielsweise durch die p-dotierte zweite, die n-dotierte dritte und die p-dotierte fünfte Halbleiterregion gebildet.

Der Wert der Energielücke in dem ersten Halbleitermaterial sei in diesem Ausführungsbeispiel um mehr als die zehnfache mittlere thermische Energie der Ladungsträger kleiner als der Wert der Energielücke in dem zweiten Halbleitermaterial. Mit zunehmender Differenz der Werte der Energielücke steigt die Eigenschaft der erfindungsgemäßen Struktur das thyristorähnliche Verhalten des parasitären pnp-Transistors zu unterdrücken.

Elektronen, die den Emitterstrom des ersten npn-Transistors tragen, überqueren hierbei den ersten Hetero-Übergang, der aus den zwei unterschiedlichen Halbleitermaterialien der zweiten, p-dotierten Halbleiterregion und der dritten n-dotierten Halbleiterregion gebildet ist, in einer ersten Richtung. Löcher, die den ersten Hetero-Übergang in der entgegengesetzten Richtung überqueren, tragen den Emitterstrom des parasitären pnp-Transistors. Eine Leitungsbandkante liegt in der Basis und in dem Emitter des ersten npn-Transistors im aktiven Vorwärtsbetrieb bei vergleichbaren Energiewerten. Ein Unterschied im Wert der Energielücke auf den beiden Seiten des ersten Hetero-Übergangs führt hiernach zu einer Stufe im Valenzband, durch die die Bewegung von Löchern über den ersten Hetero-Übergang und damit der Emitterstrom des parasitären pnp-Transistors reduziert werden.

Eine Erfindungsvariante sieht vor, dass sowohl die vierte Halbleiterregion als auch die fünfte Halbleiterregion aus dem ersten Halbleitermaterial hergestellt werden. Dies dient insbesondere dann zur Reduzierung von thyristorähnlichem Verhalten parasitärer Transistoren, wenn die Emitter des zweiten und des dritten Transistors mit dem Kollektor des ersten Transistors die gemeinsame dritte Halbleiterregion bilden. In diesem Fall sind die parasitären Transistoren aus der vierten, dritten und zweiten Halbleiterregion, beziehungsweise aus der fünften, dritten und zweiten Halbleiterregion gebildet, wobei der Emitter-Basisübergang des parasitären Transistors zwischen der vierten und der dritten respektive zwischen der fünften und der dritten Halbleiterregion entsteht. Demzufolge müssen je nach Beschaltung der drei Transistoren die parasitären Transistoren ermittelt und sofern diese durch die äußere Beschaltung zu thyristorähnlichem Verhalten neigen, deren Wirkung durch einen Hetero-Übergang reduziert oder für den bestimmten Anwendungsfall ganz überdrückt werden.

Die Änderung der Bandlücke innerhalb der zweiten beziehungsweise vierten beziehungsweise sechsten Halbleiterregion kann hierbei stetig, sprunghaft oder abgestuft ausgestaltet sein. Durch einen geeigneten Bandlückenverlauf wird ein die Minoritätsladungsträger in einer nicht-ausgeräumten Halbleiterregion beschleunigendes quasi-elektrisches Feld hervorgerufen und hiermit die Transitfrequenz $f_T$ des durch Anwendung dieser Weiterbildung des Verfahrens vorzugsweise erzeugten Hochfrequenz-Halbleiteranordnung vorteilhaft erhöht.

Eine andere vorteilhafte Ausgestaltung des Verfahrens sieht vor, dass in der zweiten Halbleiterregion an dem Rand zur dritten Halbleiterregion eine größere Bandlücke erzeugt wird als an dem Rand zur ersten Halbleiterregion. In einer anderen Weiterbildung des Verfahrens wird in der vierten oder fünften Halbleiterregion an dem Rand zur dritten Halbleiterregion eine größere Bandlücke erzeugt als an dem Rand zur sechsten, beziehungsweise siebten Halbleiterregion.

In Abhängigkeit von der benötigten Sperrspannung und der Beschaltung der drei Transistoren kann die Dotierstoffkonzentration der dritten Halbleiterregion an die bestimmte Funktion der drei Transistoren angepasst werden. Eine bevorzugte Weiterbildung der Erfindung sieht dabei vor, dass zur Erzeugung der dritten Halbleiterregion diese homogen dotiert wird. Unter der homogenen Dotierung der fünften Halbleiterregion wird verstanden, dass die Dotierstoffkonzentrationen an je zwei Orten in dieser Halbleiterregion um weniger als zwei Zehnerpotenzen, vorzugsweise um weniger als eine Zehnerpotenz voneinander abweichen.

In einer vorteilhaften Weiterbildung der Erfindung werden zumindest zwei der drei Transistoren, vorzugsweise drei Transistoren vertikal integriert. Unter vertikaler Integration wird dabei verstanden, dass sich die pn-Übergänge parallel zu einer Hauptfläche des Halbleiterkörpers erstrecken. Bevorzugt sind dabei zumindest zwei Transistoren in der Dicke des Halbleiterkörpers vertikal übereinander angeordnet, so dass diese beiden Transistoren zumindest teilweise dieselbe Chipfläche einnehmen. Die Basis-, Emitter- und Kollektorregionen der Transistoren werden zur Beschaltung entsprechend kontaktiert.

Eine bevorzugte Weiterbildung der Erfindung sieht vor, dass als erstes Halbleitermaterial $Si_{1-x}Ge_x$ und als zweites Halbleitermaterial Si verwendet wird. Neben den drei Bipolartransistoren können zusätzlich Standardbauelemente der Silizium-Technologie, wie CMOS, DMOS oder andere Feldeffekttransistoren mit und ohne Gate-Oxid oder kleine Kapazitäten in den Halbleiterkörper integriert werden.

In einer anderen Weiterbildung der Erfindung weist der Halbleiterkörper neben dem ersten Halbleitermaterial und dem zweiten Halbleitermaterial ein drittes Halbleitermaterial auf. Vorzugsweise werden dabei die zweite Halbleiterregion aus dem ersten Halbleitermaterial und die vierte und/oder die fünfte Halbleiterregion aus dem dritten Halbleitermaterial hergestellt.

Es kann vorteilhaft sein, mehrere erfindungsgemäß integrierte Bipolartransistoren lateral in geringstmöglichem Abstand zueinander anzuordnen. Hierzu ist in einer vorteilhaften Ausgestaltung der Erfindung vorgesehen, dass Übergänge zwischen den Halbleiterregionen sich im Wesentlichen parallel zu einer Hauptfläche des Halbleiterkörpers erstrecken. Hierzu werden vorzugsweise entgegengesetzt dotierte Halbleiterschichten epitaktisch aufgebracht.

Eine bevorzugte Ausgestaltung der Erfindung sieht vor, dass eine, je nach Beschaltung der Transistoren als Kollektor oder als Emitter dienende Halbleiterregion zumindest eines Transistors an das Substrat grenzt und mit einer Verbindungselektrode von der Wafer-Vorderseite her elektrisch kontaktiert wird. In diesem Fall ist also keine Rückseitenkontaktierung des Halbleiterkörpers nötig.

Bevorzugt ist in einer Weiterbildung der Erfindung vorgesehen, dass die vierte Halbleiterregion und die fünfte Halbleiterregion voneinander lateral beabstandet hergestellt werden. Die laterale Beabstandung der vierten Halbleiterregion und der fünften Halbleiterregion wird insbesondere durch eine Ätzung einer trennenden Struktur, insbesondere eines Grabens, oder durch örtlich selektives, epitaktisches Aufwachsen der vierten und fünften Halbleiterregion erzeugt. Die Beabstandung dient vorteilhafterweise zugleich als Isolation, indem die vierte und fünfte Halbleiterregion durch ein Gas oder Vakuum getrennt bleiben. In einer alternativen Weiterbildung hingegen werden die vierte Halbleiterregion und die fünfte Halbleiterregion voneinander durch einen Isolator isoliert. Als Isolator dient beispielsweise $SiO_2$.

Ein weiterer Aspekt der Erfindung ist ein Mehrschichtbauelement, mit Halbleiterschichten eines zweiten Leitungstyps und Halbleiterschichten eines ersten, dem zweiten Leitungstyp entgegengesetzten Leitungstyps. Das Mehrschichtbauelement bildet in einem Halbleiterkörper zumindest drei BipolarTransistoren. Dabei bilden Halbleiterschichten des zweiten Leitungstyps die Basen der Transistoren, während Halbleiterschichten des ersten Leitungstyps neben zumindest einem Kollektor und zumindest einem Emitter eine Zwischenbasisschicht bilden. Die Zwischenbasisschicht grenzt an die Halbleiterschichten des zweiten Leitungstyps. Dabei besteht die Zwischenbasisschicht aus einem ersten Halbleitermaterial und zumindest eine Halbleiterschicht des zweiten Leitungstyps besteht aus einem zweiten Halbleitermaterial.

Erfindungsgemäß ist der Wert der Energielücke in dem zweiten Halbleitermaterial um mindestens die mittlere thermische Energie der Ladungsträger kleiner, als der Wert der Energielücke in dem ersten Halbleitermaterial. Vorzugsweise beträgt die Differenz der Werte der Energielücken mindestens das fünffache der mittleren thermischen Energie der Ladungsträger.

Eine bevorzugte Ausgestaltung des Mehrschichtbauelementes der Erfindung sieht vor, dass die Halbleiterschichten des ersten und zweiten Leitungstyps im Wesentlichen parallel zu einer Hauptfläche des Halbleiterkörpers angeordnet sind. In der Hauptfläche ist das Kristallgitter beispielsweise in einer <100>, <110> oder <111> Orientierung. Die Hauptfläche bietet dabei die Möglichkeit der Strukturierung des Halbleiters, insbesondere der drei Transistoren, beispielsweise mittels photolithographischer Prozesse. Vorzugsweise ist die Hauptfläche dabei die Vorderseite eines Wafers.

In einer vorteilhaften Ausgestaltung der Erfindung werden alle in dem Halbleiterkörper kontaktierten Halbleiterschichten des ersten und zweiten Leitungstyps zur Vorderseite des Halbleiterkörpers kontaktiert. Die Vorderseitenkontaktierung erfolgt mittels einer Metallisierung, die für Hochfrequenzschaltungen kurze Verbindungen zwischen den Kontakten der Bauelemente mit einer vernachlässigbaren Induktivität ermöglicht. Als Vorderseite wird beispielsweise die Seite eines Wafers angesehen, die die Kontaktflächen für Anschlüsse der Bauelemente aufweist. Durch die Vorderseitenkontaktierung werden bei den Mehrschichtbauelementen mit relativ dünnen Halbleiterbereichen niedrige Anschlusswiderstände erreicht, so dass sich insbesondere das für den Hochfrequenzbereich wichtige, transiente Verhalten verbessert.

Ein weiterer Aspekt der Erfindung ist eine Verwendung des zuvor dargestellten Mehrschichtbauelementes als hochsperrendes aktives Bauelement, in einem Spannungsbereich in dem das transiente Verhalten wesentlich von der Laufzeit durch die Raumladungszone zwischen dem Kollektor und der Basis zumindest eines die maximale Nutzspannung begrenzenden Transistors bestimmt ist. Um eine möglichst große Raumladungszone und für Hochstromanwendungen große Kontaktflächen zu erzielen ist der Kollektor dieses Transistors vorteilhaftervveise von der Rückseite des Wafers kontaktiert.

Die Mehrschichtbauelemente lassen sich insbesondere als hochsperrende aktive Bauelemente verwenden. In einem Spannungsbereich, in dem das transiente Verhalten eines Transistors von der Laufzeit durch die Basis-Kollektor-Raumladungszone bestimmt wird, lässt sich beispielsweise mittels einer zweistufigen Tetrode ein etwa 1,5- bis 3-faches Johnson-Produkt eines hochsperrenden Transistors erreichen. Während die Sperrfähigkeit einer zweistufigen Tetrode dreibis zehnmal so hoch ist wie die eines Transistors vergleichbarer Kollektordotierung, verhält sich die Transitfrequenz $f_T$ umgekehrt proportional zur Wurzel der Basis-Kollektor-Spannung, so dass sich durch ein Ersetzen eines hochsperrenden Transistors durch eine zweistufige Tetrode das Johnson-Produkt um einen Faktor $\sqrt{3}$ bis $\sqrt{10}$ erhöhen lässt. Dieser Sachverhalt lässt sich auf Mehrschichtbauelementen mit drei integrierten Transistoren entsprechend anwenden.

Typische Anwendungsgebiete hochsperrender Mehrschichtbauelemente umfassen aktive Elemente in Schaltnetzteilen sowie die Ansteuerung piezoelektrischer Aktoren in Druckköpfen, Mikrodosierpumpen oder Lautsprechern. In Schaltnetzteilen lassen sich durch Verwendung von erfindungsgemäßen Mehrschichtbauelementen insbesondere die Schaltverluste deutlich verringern.

Bei einer integrierten Schaltung lässt sich bei der Ansteuerung piezoelektrischer Aktoren im Spannungsbereich von beispielsweise 200 V mittels erfindungsgemäßen Mehrschichtbauelementen die Kollektor-Schichtdicke von Einzeltransistoren reduzieren. Hierdurch lässt sich die Packungsdichte innerhalb der integrierten Schaltung erhöhen und eine erhebliche Kostenreduzierung erreichen.

Ein derartiges Mehrschichtbauelement kann als höchstfrequenztaugliches aktives Bauelement in einem Frequenzbereich verwendet werden, in dem das transiente Verhalten wesentlich durch den Miller-Effekt beeinflusst wird.

In einem Frequenzbereich, in dem das transiente Verhalten eines Transistors merklich durch den Miller-Effekt beeinflusst wird, lässt sich, aufgrund des höheren erzielbaren Spannungshubes $\Delta U_c$ und der Vermeidung des Miller-Effektes mittels eines Mehrschichtbauelements ein 3- bis 10-faches Johnson-Produkt im Vergleich mit einem Transistor erreichen. Typische Anwendungen hochfrequenztauglicher Mehrschichtbauelemente liegen beispielsweise in der Mobilkommunikation sowie in der Signalaufbereitung und der Ansteuerung optischer Modulatoren für die Datenübertragung in faseroptischen Netzen.

Ferner lässt sich unter Verwendung der erfindungsgemäßen Mehrschichtbauelemente anstelle von Transistoren eine höhere Leistungsverstärkung pro Verstärkerstufe erreichen und hierdurch die Anzahl an Verstärkerstufen und die Ruhestromaufnahme verringern. Bei mobilen Anwendungen wie Handys und Notebooks lassen sich hiernach die Ladeintervalle der Energieträger, insbesondere von Akkumulatoren, erheblich vergrößern.

Während im unteren Hochfrequenzbereich im Bereich von wenigen GHz oder unterhalb einem GHz kostengünstige, ausgereifte und einfache Herstellungsverfahren für integrierte Schaltungen zur Verfügung stehen, ist für Anwendungen in Frequenzbereichen oberhalb des X-Bandes häufig ein Übergang zu anderen, weniger kostengünstigen und in der Prozessierung aufwendigeren Halbleitermaterialsystemen wie beispielsweise GaAs nötig. Durch den Einsatz der erfindungsgemäßen Mehrschichtbauelemente wird der mit einem gegebenen Halbleitermaterialsystem, insbesondere mit Silizium, zugängliche Frequenzbereich erweitert. Hierdurch werden die Herstellungskosten für Einrichtungen zur Signalaufbereitung in hohen Frequenzbereichen erheblich reduziert.

Bei der Datenübertragung in Glasfasernetzen werden durch Trägerfrequenzen von typischerweise etwa 200 THz hohe Modulationsraten ermöglicht. Oberhalb einer Datenrate von etwa 10 Gb/s wird hierbei auf den Strahl einer kontinuierlich betriebenen Laserdiode durch einen nachgeschalteten optischen Modulator ein Signal aufgeprägt. Als optische Modulatoren dienen insbesondere Mach-Zehnder-Interferometer, die Steuerspannungen von bis zu etwa 10 V erfordern. Anders als mit den bekannten Halbleiterbauelementen können vermittels erfindungsgemäßen Mehrschichtbauelementen hochfrequente Ansteuersignale im benötigten Spannungsbereich auf einfache und kostengünstige Weise zur Verfügung gestellt werden.

Ebenfalls ein Gegenstand der Erfindung ist eine Halbleiteranordnung von mindestens drei Bipolartransistoren in einem Halbleiterkörper. Die jeweilige Basis der Bipolartransistoren ist aus einem schichtförmigen Halbleitergebiet eines zweiten Leitungstyps gebildet. Ein schichtförmiges Zwischenbasisgebiet eines ersten (dem zweiten Leitungstyp entgegensetzten) Leitungstyps grenzt an jedes schichtförmige Halbleitergebiet des zweiten Leitungstyps der drei Bipolartransistoren. Die Halbleiteranordnung weist zumindest einen Hetero-Übergang zwischen dem Zwischenbasisgebiet und einem der Halbleitergebiete des ersten Ladungstyps auf.

Eine erste Ausgestaltungsvariante der Erfindung sieht vor, dass das Zwischenbasisgebiet einen Kollektor mindestens eines Bipolartransistors und Emitter zumindest zweier Bipolartransistoren bildet. Diese Anordnung der Bipolartransistoren ermöglicht eine vorteilhafte Schaltungsanordnung als Teil eines Differenzverstärkers oder Mischers. Beispielsweise können zwei dieser Halbleiteranordnungen als multiplikative Mischstufe verschaltet werden.

In einer zweiten Ausgestaltungsvariante der Erfindung bildet das Zwischenbasisgebiet einen Emitter mindestens eines Bipolartransistors und Kollektoren zumindest zweier Bipolartransistoren. Diese Ausgestaltungsvariante ermöglicht beispielsweise die Integration von Höchstfrequenz-ECL-Schaltkreisen.

In einer bevorzugten Weiterbildung der Erfindung ist vorgesehen, dass das Zwischenbasisgebiet homogen dotiert ist. Unter der homogenen Dotierung des Zwischenbasisgebiets wird verstanden, dass die Dotierstoffkonzentrationen an je zwei Orten in diesem Gebiet um weniger als zwei Zehnerpotenzen, vorzugsweise um weniger als eine Zehnerpotenz voneinander abweichen.

Für den Betrieb einer Halbleiteranordnung vorzugsweise als verzweigte Kaskode werden im Allgemeinen mindestens der Kollektorbereich, die Basisbereiche und der Emitterbereich elektrisch kontaktiert. In einer anderen Ausführungsform der Erfindung weist auch das Zwischenbasisgebiet einen elektrischen Kontakt auf. Hierdurch lässt sich eine mögliche Schwingungsneigung unterdrücken.

Das Potential, das sich in einem unkontaktierten Zwischenbasisgebiet einstellt, hängt einerseits vom Kollektorstrom ab, bestimmt aber andererseits den Kollektorstrom mit. Aufgrund der endlichen Lauf- und Ladezeiten reagiert das Potential im Zwischenbasisgebiet verzögert auf Änderungen des Kollektorstromes, genauso, wie sich der Kollektorstrom erst zeitversetzt auf eine Potentialänderung im Zwischenbasisgebiet anpasst. Hierdurch ergibt sich ein Regelkreis mit einer Zeitkonstante. Einzelne Ausführungsformen neigen unterhalb der Zeitkonstante zum Schwingen. Über eine Festlegung der Spannung in dem Zwischenbasisgebiet mittels eines elektrischen Kontaktes lässt sich diese Schwingungsneigung unterdrücken.

In einer vorteilhaften Weiterbildungen dieser Halbleiteranordnung im Hochfrequenzbereich ist die Dotierstoffkonzentration spezifiziert, indem das Zwischenbasisgebiet eine Dotierstoffkonzentration von mindestens $1 \cdot 10^{17}$ cm$^{-3}$ vorzugsweise mehr als $5 \cdot 10^{17}$ cm$^{-3}$ aufweist. Durch die homogene Dotierung kann das Zwischenbasisgebiet, das den Kollektor des ersten Transistors bildet an bestimmte Hochfrequenzeigenschaften dieses Transistors besser angepasst werden.

Weiterhin kann die Hochfrequenzcharakteristik der Halbleiteranordnung der Erfindung verbessert werden, indem in einer bevorzugten Weiterbildung der Erfindung das Zwischenbasisgebiet eine Dicke von weniger als 200nm, vorzugsweise von weniger als 100nm aufweist. Mit abnehmender Dicke können die Hochfrequenzeigenschaften verbessert werden. Dies ist insbesondere deshalb möglich, da ein hochdotiertes Gebiet zusätzlich zur erfindungsgemäßen homogen dotierten Zwischenbasis nicht benötigt wird.

Bevorzugte Verwendungen der Halbleiteranordnung sind eine verzweigte Kaskodenschaltung eines ECL-Gatters und eine verzweigte Kaskodenschaltung eines Gilbert-Mischers.

Die Erfindung soll nachfolgend im Zusammenhang mit mehreren schematisierten Zeichnungen erläutert werden.

Im Einzelnen zeigt

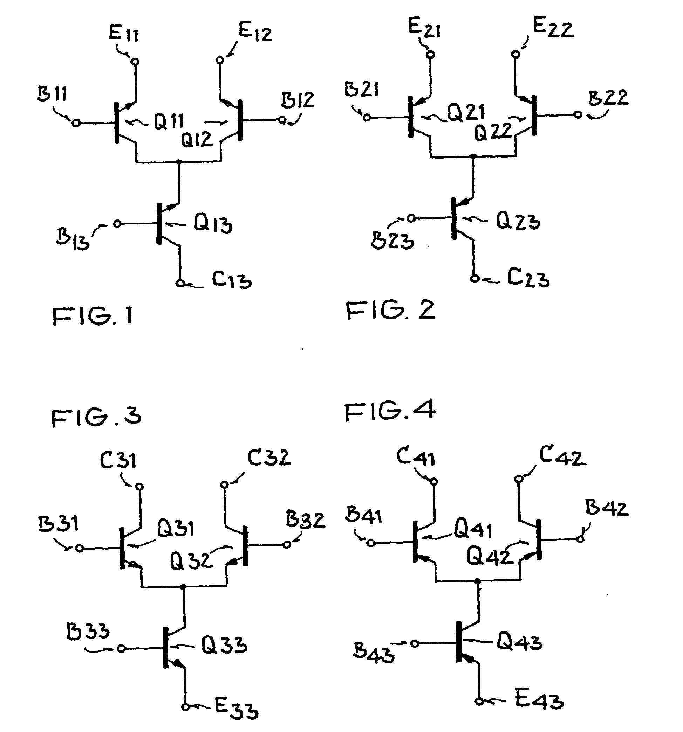

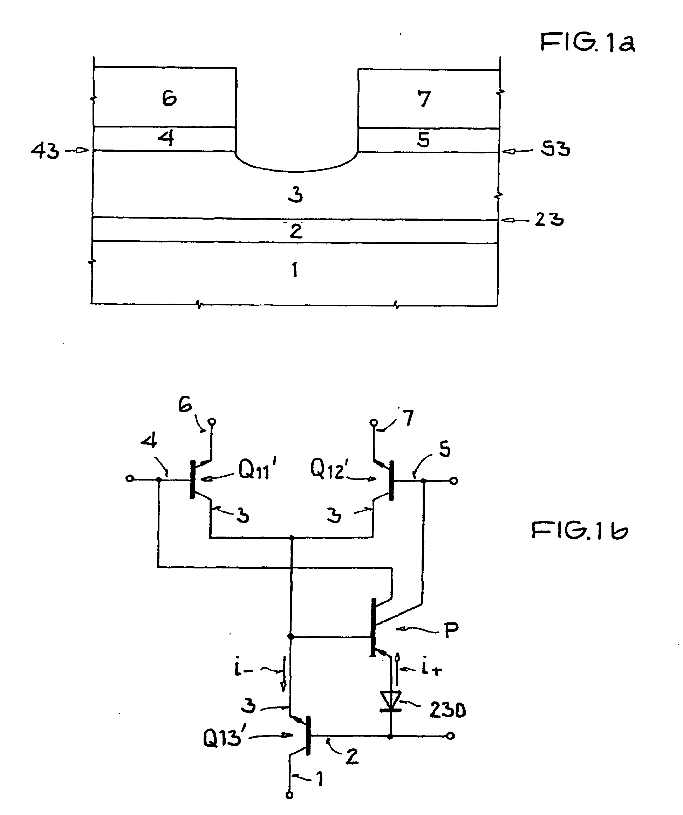

Fig. 1 einen ersten Schaltungsteil einer integrierten Halbleiteranordnung mit drei npn-Transistoren;

Fig. 1a eine Halbleiteranordnung mit vertikal angeordneten Halbleiterschichten, die die Transistoren gemäß der Fig.1 bilden;

Fig. 1 b ein Ersatzschaltbild für die Halbleiteranordnung der Fig. 1a;

Fig. 2 einen zweiten Schaltungsteil einer integrierten Halbleiteranordnung mit drei pnp-Transistoren;

Fig. 3 einen dritten Schaltungsteil einer integrierten Halbleiteranordnung mit drei npn-Transistoren; und

Fig. 4 einen vierten Schaltungsteil einer integrierten Halbleiteranordnung mit drei pnp-Transistoren.

Aktive Bipolarbauelemente sind unter anderem die Bipolartransistoren in den Typen npn und pnp, im Folgenden als Transistoren bezeichnet. Wichtig zur Charakterisierung von aktiven Bauelementen wie beispielsweise den Transistoren sind elektrischen Kenngrößen für den Kleinsignalbetrieb, wie die Stromverstärkung $\beta$ und die Early-Spannung $V_a$. Hierbei ist die Stromverstärkung $\beta$ umgekehrt proportional zur Gummelzahl $G_B$, dem Dotierstoffintegral über die nicht-ausgeräumte Basis.

Durch eine Erhöhung der Basis-Kollektor-Spannung wird die nicht-ausgeräumte Basis verkleinert und die Stromverstärkung $\beta$ erhöht. Die relative Änderung der Stromverstärkung $\beta$ ist um so größer, je größer die Stromverstärkung $\beta$ ist, so dass das Produkt aus der Early-Spannung $V_a$ und der Stromverstärkung $\beta$ begrenzt ist.

Wichtig bei Verwendung aktiver Bipolarbauelemente als Verstärkerelemente oder Schalter sind ferner das transiente Verhalten und die Sperrfähigkeit. Eine Kenngröße zur Charakterisierung des transienten Verhaltens ist die Transitfrequenz $f_T$. Der am Kollektor erzielbare Spannungshub $\Delta U_C$ stellt eine Kenngröße für die Sperrfähigkeit dar, die umgekehrt proportional zur Höhe der Kollektordotierung ist.

Bei hochsperrenden Transistoren wird das transiente Verhalten vor allem von der Kollektor-Laufzeit bestimmt. Hierbei durchqueren die Ladungsträger eine gesperrte Raumladungszone mit Sättigungsgeschwindigkeit, so dass die Kollektor-Laufzeit bei der maximalen Kollektorspannung umgekehrt proportional zur Höhe der Kollektordotierung ist. Im Hochfrequenzbereich wird das transiente Verhalten von der Basis-Laufzeit und der Basis-Ladezeit bestimmt. Bei einer Signalübertragung wird die Basis-Emitter-Kapazität umgeladen. Die Umladung erfolgt um so schneller, je höher die Stromdichte ist. Hierdurch wächst die Transitfrequenz $f_T$ zunächst mit steigendem Kollektorstrom an. Wird die Dichte der beweglichen Ladungsträger in der Kollektor-Driftzone vergleichbar mit der Ladungsdichte der Ionenrümpfe, erhöht sich die wirksame Basisweite (Kirk-Effekt). Hierdurch wird die Basis-Laufzeit vergrößert und die Transitfrequenz $f_T$ sinkt bei hohen Stromdichten wieder ab. Ferner ist die Stromdichte bei einsetzendem Kirk-Effekt proportional und die Basis-Ladezeit umgekehrt proportional zur Höhe der Kollektordotierung. Auch unter Vernachlässigung von Basis-Lauf- und Ladezeit ergibt sich aufgrund der Laufzeit durch die Basis-Kollektor-Raumladungszone eine materialabhängige Obergrenze des Johnson-Produkts, d. h., dem Produkt aus Transitfrequenz $f_T$ und Spannungshub $\Delta U_c$.

Bei Hetero-Bipolartransistoren (HBT) werden die elektrischen Eigenschaften insbesondere die Hochfrequenzeigenschaften mittels Hetero-Übergängen verbessert. Als Heteroübergang wird ein Übergang von einem ersten Halbleiterbereich eines ersten Halbleitermaterials zu einem zweiten Halbleiterbereich eines zweiten Halbleitermaterials bezeichnet. Hierbei kann der Übergang sowohl abrupt, d.h. in einem sprunghaften Wechsel zwischen dem ersten und dem zweiten Halbleitermaterial erfolgen, als auch abgestuft oder stetig ausgeführt sein, indem die Zusammensetzung in einem Übergangsbereich (Mischbereich) des Halbleitermaterials in Stufen oder stetig variiert.

Ein Heteroübergang eines Hetero-Bipolartransistoren zwischen Basis und Kollektor ermöglicht es, dass der Kollektorstrom eines Transistors proportional zur intrinsischen Ladungsträgerkonzentration in der Basis ist, während die intrinsische Ladungsträgerkonzentration in dem Halbleiter exponentiell mit einem sinkenden Wert der Bandlücke ansteigt. Durch eine Verringerung der Bandlücke in der Basis eines Transistors wird hiernach der Kollektorstrom und mithin die Stromverstärkung β erhöht. Gleichzeitig hängt die Sperrfähigkeit einer Transistors unter anderem von der Durchbruchfeldstärke in der Kollektor-Driftzone ab, die näherungsweise proportional zur Quadratwurzel aus der dritten Potenz des Wertes der Bandlücke im Kollektor ist. Hiernach lässt sich durch einen kleineren Wert der Bandlücke in der Basis als im Kollektor eine hohe Sperrfähigkeit mit einer hohen Stromdichte, und mit einer hohen Transitfrequenz $f_T$, die oberhalb von mehreren GHz liegt, verbinden. Ein kleinerer Wert der Bandlücke in der Basis als im Kollektor lässt sich insbesondere mit Hilfe eines Heteroüberganges zwischen der Basis und dem Kollektor erzielen.

In einem Hetero-Bipolartransistoren (HBT) mit einem Heteroübergang zwischen Basis und Emitter liegt im aktiven Vorwärtsbetrieb die Kante des Bandes, das im Emitter die Majoritäts-Ladungsträger führt, in Basis und Emitter bei vergleichbaren Energien. Bei unterschiedlichen Werten der Bandlücke in der Basis und im Emitter liegt die Kante des Bandes, das in der Basis die Majoritäts-Ladungsträger führt, in Basis und Emitter bei unterschiedlichen Energien. Wird insbesondere der Wert der Energielücke in der Basis kleiner als im Emitter gewählt, so wird im aktiven Vorwärtsbetrieb des Transistors die Bewegung von Basis-Majoritätsladungsträgem in den Emitter mittels einer Energiebarriere unterdrückt, der Basisstrom verringert und die Stromverstärkung β erhöht. Ein kleinerer Wert der Bandlücke in der Basis als im Emitter kann insbesondere mit Hilfe eines Heteroüberganges zwischen der Basis und dem Emitter erzielt werden.

Die Basis-Laufzeit lässt sich durch ein quasi-elektrisches Feld reduzieren, indem in einem nicht-ausgeräumten Halbleiterbereich mit einem ortsunabhängigen elektrochemischen Potential und einer ortsunabhängigen Kante des Majoritätsladungsträgerbandes eine räumliche Änderung der Energielücke zu einer Bandkantenneigung im Minoritätsladungsträgerband führt. Hierdurch erfahren die Minoritätsladungsträger auch im nicht-ausgeräumten Halbleiterbereich ein als quasi-elektrisch bezeichnetes, beschleunigendes Feld, so dass die Basis-Laufzeit verringert und die Transitfrequenz $f_T$ erhöht wird.

Des Weiteren lassen sich die elektrischem Eigenschaften aktiver Halbleiterbauelemente verbessern, indem ein einzelner Transistor in Emitterschaltung mit einer resistiven Last am Kollektor ersetzt wird durch eine - diskret aufgebaute oder lateral integrierte - Kaskodenschaltung aus einem angesteuerten Transistor in Emitterschaltung und einem oder zwei Hilfstransistoren in Basisschaltung. Hierbei speist der Hilfstransistor die resistive Last. Aufgrund des niedrigen Eingangswiderstandes des Hilfstransistors erfährt der angesteuerte Transistor nur einen geringen Spannungshub $\Delta U_c$, so dass die Kaskodenschaltung bei der selben Stromverstärkung β wie der des angesteuerten Transistors eine höhere Early-Spannung $V_a$ aufweist und der angesteuerte Transistor niedersperrend und schnell ausgeführt werden kann. Zur Stromverstärkung wird ein Transistor meist in Emitterschaltung betrieben. Demgegenüber ist die Sperrfähigkeit in Basisschaltung typischerweise dreimal bis zehnmal so hoch. Durch Kaskodieren eines Transistors als Hilfstransistor mit einem niedersperrenden angesteuerten Transistor werden hiernach der erzielbare Spannungshub $\Delta U_C$ und das Johnson-Produkt erhöht. Weiterhin wird durch den Übergang zu der Kaskodenschaltung oder einer verzweigten Kaskodenschaltung der Miller-Effekt reduziert und die Transitfrequenz $f_T$ erhöht. Hierdurch lassen sich Frequenzen im Bereich von mehreren GHz erzielen.

Wichtig für die Verwendung aktiver Bauelemente ist ferner die erzielbare Leistungsverstärkung. Während der angesteuerte Transistor einer Kaskodenschaltung zur Stromverstärkung verwendet wird, dient der Hilfstransistor als Impedanzwandler zur Spannungsverstärkung. Die mit Hilfe der Kaskodenschaltung oder der im Folgenden beschriebenen verzweigten Kaskodenschaltung erzielte Leistungsverstärkung berechnet sich als Produkt der Leistungsverstärkungen des angesteuerten Transistors und des jeweiligen Hilfstransistors.

Fig. 1 zeigt einen Teil einer Schaltung mit drei npn-Bipolartransistoren Q11, Q12 und Q13, die zusammen in einen Halbleiterkörper integriert werden. Der Schaltungsteil wird als verzweigte Kaskodenschaltung beispielsweise als Bestandteil einer ECL-Logik verwendet. Dabei ist der Emitter eines ersten Transistors Q13 mit den Kollektoren des zweiten und dritten Transistors Q12 und Q13 verbunden. In den Halbleiterkörper integriert, bilden dieser Emitter und diese beiden Kollektoren ein gemeinsames n-dotiertes Halbleitergebiet. Eine, zu der Anordnung der Fig. 1 komplementäre Anordnung von pnp-Transistoren ist in der Fig. 2 dargestellt. Auch in diesem Fall bildet der Emitter des Transistors Q23 mit den Kollektoren der Transistoren Q21 und Q22 eine gemeinsame n-dotierte Halbleiterregion.

Fig. 3 zeigt eine andere Anordnung von integrierten npn-Transistoren. In diesem Ausführungsbeispiel sind die beiden Emitter der Transistoren Q31 und Q32 mit dem einen Kollektor des Transistors Q33 verbunden. Ein derartiger Schaltungsteil ist beispielsweise Bestandteil eines Differenzverstärkers oder eines Mischers. Beispielsweise können zwei dieser Schaltungsteile zu einer multiplikativen Mischstufe zusammen geschaltet werden. In diesem Ausführungsbeispiel bilden die beiden Emitter der Transistoren Q31 und Q32 mit dem einen Kollektor des Transistors Q33 eine n-dotierte Halbleiterregion. Wiederum ist eine, zur der Fig. 3 komplementäre Anordnung von pnp-Transistoren in der Fig. 4 dargestellt.

Fig. 1a zeigt einen schematischen Querschnitt durch einen Halbleiterkörper mit mehreren Halbleiterschichten 1, 2, 3, 4, 5, 6 und 7. Diese Halbleiteranordnung weist zunächst einen n-dotierten Kollektorbereich 1, einen auf dem Kollektorbereich 1 aufliegenden p-dotierten Basisbereich 2 aus einem ersten Halbleitermaterial und einen auf dem Basisbereich 2 aufliegenden n-dotierten Zwischenbasisbereich 3 aus einem zweiten Halbleitermaterial auf. Ferner zeigt Fig. 1a zwei getrennte, auf dem Zwischenbasisbereich 3 aufliegende, p-dotierte Basisbereiche 4 und 5 auf denen jeweils wiederum ein n-dotierter Emitterbereich 6, beziehungsweise 7 aufliegt. Zwischen dem Basisbereich 2 und dem Zwischenbasisbereich 3 ist ein Hetero-Übergang 23 ausgebildet. In dem Halbleitermaterial des Basisbereichs 2 liegt die Valenzbandkante energetisch deutlich höher als in dem Halbleitermaterial des Zwischenbasisbereichs 3, während die Leitungsbandkanten in beiden Halbleitermaterialien vergleichbare Energiewerte aufweisen.

Die Halbleiteranordnung enthält einen ersten, einen zweiten und einen dritten npn-Transistor. Der erste npn-Transistor besteht aus dem ersten Emitterbereich 6 als Emitter, dem ersten Basisbereich 4 als Basis und dem Zwischenbasisbereich 3 als Kollektor. Der zweite npn-Transistor umfasst den zweiten Emitterbereich 7 als Emitter, den zweiten Basisbereich 6 als Basis und den Zwischenbasisbereich 3 als Kollektor. Der dritte npn-Transistor wird gebildet von dem Zwischenbasisbereich 3 als Emitter, dem dritten Basisbereich 2 als Basis und dem Kollektorbereich 1 als Kollektor. Darüber hinaus enthält die Halbleiteranordnung einen parasitären pnp-Transistor mit zwei Kollektoren, gebildet von dem dritten Basisbereich 2 als Emitter, dem Zwischenbasisbereich 3 als Basis und dem ersten Basisbereich 4 sowie dem zweiten Basisbereich 5 als Kollektoren. Zudem kann sich ein weiterer parasitärer pnp-Transistor mit dem ersten Basisbereich 4 und dem zweiten Basisbereich 5 als Emitter, beziehungsweise als Kollektor und dem Zwischenbasisbereich 3 als Basis. Die Anordnung der Halbleiterschichten 1, 2, 3, 4, 5, 6 und 7 der Fig. 1a ensprechen daher der Schaltung der Fig. 1.

Der pn-Übergang zwischen dem dritten Basisbereich 2 und dem Zwischenbasisbereich 3 dient gleichzeitig als Emitterdiode des dritten npn-Transistors und des parasitären pnp-Transistors. Elektronen, die aus dem Zwischenbasisbereich 3 in den dritten Basisbereich 2 fließen, tragen den Emitterstrom des dritten npn-Transistors. Die Löcher hingegen, die sich aus dem dritten Basisbereich 2 in den Zwischenbasisbereich 3 bewegen, tragen den Emitterstrom des parasitären pnp-Transistors. Während durch den Heteroübergang 23 der Fluss von Elektronen aus dem Zwischenbasisbereich 3 in den dritten Basisbereich 2 nicht behindert wird, wird im aktiven Vorwärtsbetrieb des dritten Transistors die Anzahl von Löchern, die sich aus dem dritten Basisbereich 2 in den Zwischenbasisbereich 3 bewegen, aufgrund der unterschiedlichen energetischen Lagen der Valenzbandkanten in dem ersten und dem zweiten Halbleitermaterial reduziert.

Aus diesen physikalischen Effekten ist das Ersatzschaltbild der Fig. 1b hergeleitet. Der erste npn-Transistor der Halbleiteranordnung aus Fig. 1a wird wiedergegeben durch ein npn-Transistorsymbol Q11'. Der zweite npn-Transistor wird durch ein npn-Transistorsymbol Q12' und der dritte npn-Transistor durch ein npn-Transistorsymbol Q13' wiedergegeben. Zudem ist der durch die äußere Beschaltung maßgebliche parasitäre pnp-Transistor P mit zwei Kollektoranschlüssen dargestellt. Die Kollektoren der npn-Transistoren Q11' und Q12', die Basis des parasitären pnp-Transistors P und der Emitter des npn-Transistors Q13' sind miteinander verbunden. Ein erster Kollektor des pnp-Transistors P ist mit der Basis des npn-Transistors Q11', ein zweiter Kollektor des parasitären pnp-Transistors P ist mit der Basis des npn-Transistor Q12' kurzgeschlossen.

Der Strom durch den pn-Übergang aus dem dritten Basisbereich 2 und dem Zwischenbasisbereich 3 wird in dem Ersatzschaltbild aufgespalten in einen Elektronenstrom $i_-$ und einen Löcherstrom $i_+$. Der Elektronenstrom $i_-$ stellt den Emitterstrom des npn-Transistors Q13', der Löcherstrom $i_+$ den Emitterstrom des parasitären pnp-Transistors P dar.

Der Heteroübergang 23 beeinflusst den Löcherstrom $i_+$ wesentlich stärker als den Elektronenstrom $i_-$. Die Wirkung des Heteroübergangs 23 lässt sich im Ersatzschaltbild durch eine Diode 230 im Strompfad des Löcherstromes $i_+$ wiedergeben: Der Emitter des parasitären pnp-Transistors P ist über die Diode 230 mit der Basis des npn-Transistors Q13' verbunden. Dabei ist die Diode 230 so gepolt, dass sie den Fluss von Löchern in den Emitter des parasitären pnp-Transistors P signifikant reduziert und vorteilhafterweise ganz unterdrückt. Der parasitäre pnp-Transistor P bleibt im Ersatzschaltbild aufgrund der Diode 230 im wesentlichen inaktiv, so dass die Wirkung des parasitären pnp-Transistors P in erster Näherung vernachlässigt werden kann. Das tatsächliche elektrische Verhalten der Halbleiteranordnung lässt sich demgemäß durch ein vereinfachtes Ersatzschaltbild mit der Schaltungstopologie der Beispielschaltung der Fig. 1 beschreiben.

In einer anderen Weiterbildung dieser Ausgestaltung der Erfindung wird der zweite Halbleiterbereich 2 in einem anderen Halbleitermaterial ausgeführt als die erste Halbleiterregion 1. Hierdurch lässt sich insbesondere die Durchbruchspannung der Diode zwischen der ersten Halbleiterregion 1 und der zweiten Halbleiterregion 2 erhöhen, ohne die transienten Eigenschaften der Transistoren negativ beeinträchtig würden. Durch eine abgestufte oder stetige Ausgestaltung eines Heteroüberganges zwischen der ersten Halbleiterregion 1 und der zweiten Halbleiterregion 2 lassen sich insbesondere piezoelektrische Effekte sowie Verspannungen des Kristallgitters bei Gitterfehlanpassungen verringern und ein ungehinderter Fluss von Ladungsträgern sicherstellen.

In einer anderen Weiterbildung dieser Ausgestaltung der Erfindung wird die vierte Halbleiterregion 4 oder die fünfte Halbleiter 5 in einem anderen Halbleitermaterial ausgeführt als die dritte Halbleiterregion 3. Durch eine abgestufte oder stetige Ausgestaltung des Heteroüberganges 43 zwischen der dritten Halbleiterregion 3 und der vierten Halbleiterregion 4, sowie des Heteroüberganges 53 zwischen der dritten Halbleiterregion 3 und der fünften Halbleiterregion 5 lassen sich piezoelektrische Effekte und Verspannungen des Kristallgitters bei Gitterfehlanpassungen verringern. Ferner lässt sich ein ungehinderter Fluss von Ladungsträgern auch in den Fällen sicherstellen, bei denen durch einen sprunghaften Heteroübergang 43, 53 die Bewegung von Ladungsträgern ersten Leitungstyps aus dem ersten und zweiten Basisbereich 4, 5 in den Zwischenbasisbereich 3 durch einen Bandkantensprung behindert wird.

**Patentansprüche**

1. **Verfahren** zur Integration von drei Bipolartransistoren (Q11,Q12, Q13, Q21, Q22,Q23, Q31,Q32, Q33, Q41, Q42, Q43) in einen Halbleiterkörper, indem

    - eine erste schichtförmige Halbleiterregion (1) eines ersten Leitungstyps erzeugt wird,
    - eine zweite schichtförmige Halbleiterregion (2) eines zweiten, dem ersten Leitungstyp entgegengesetzten Leitungstyps erzeugt wird, die an die erste Halbleiterregion (1) grenzt,
    - eine dritte schichtförmige Halbleiterregion (3) des ersten Leitungstyps erzeugt wird, die an die zweite Halbleiterregion (2) grenzt,
    - eine vierte schichtförmige Halbleiterregion (4) und eine fünfte schichtförmige Halbleiterregion (5) des zweiten Leitungstyps erzeugt werden, die an die dritte Halbleiterregion (3) grenzen, wobei die zweite schichtförmige Halbleiterregion (2), die vierte schichtförmige Halbleiterregion (4) und die fünfte schichtförmige Halbleiterregion (5) die Basen der drei Bipolartransistoren (Q11, Q12, Q13, Q21, Q22, Q23, Q31, Q32, Q33, Q41, Q42, Q43) bilden,
    - eine sechste schichtförmige Halbleiterregion (6) und eine siebte schichtförmige Halbleiterregion (7) des ersten Leitungstyps erzeugt werden, wobei die sechste Halbleiterregion (6) an die vierte Halbleiterregion (4) und die siebte Halbleiterregion (7) an die fünfte Halbleiterregion (5) grenzt,
    - die zweite Halbleiterregion (2) und/oder die vierte Halbleiterregion (4) und/oder die fünfte Halbleiterregion (5) aus einem ersten Halbleitermaterial hergestellt wird, und
    - die dritte Halbleiterregion (3) aus einem zweiten Halbleitermaterial hergestellt wird, wobei das erste Halbleitermaterial und das zweite Halbleitermaterial derart hergestellt werden, dass
    - der Wert der Energielücke in dem ersten Halbleitermaterial um mindestens die mittlere thermische Energie der Ladungsträger kleiner ist, als der Wert der Energielücke in dem zweiten Halbleitermaterial.

2. Verfahren nach Anspruch 1, wobei zur Erzeugung der dritten Halbleiterregion (3) diese homogen dotiert wird.

3. Verfahren nach einem der vorhergehenden Ansprüche, wobei zumindest zwei der drei Transistoren (Q11,Q12,Q13, Q21,Q22,Q23, Q31, Q32, Q33, Q41,Q42,Q43) vertikal integriert werden.

4. Verfahren nach einem der vorhergehenden Ansprüche, wobei als erstes Halbleitermaterial $Si_{1-x}Ge_x$ und als zweites Halbleitermaterial Si verwendet wird.

5. Verfahren nach einem der vorhergehenden Ansprüche, wobei die zweite Halbleiterregion (2) aus dem ersten Halbleitermaterial und die vierte (4) und die fünfte Halbleiterregion (5) aus einem dritten Halbleitermaterial hergestellt werden.

6. Verfahren nach einem der vorhergehenden Ansprüche, wobei Übergänge zwischen den Halbleiterregionen (1, 2, 3, 4, 5, 6, 7) sich im wesentlichen parallel zu einer Hauptfläche des Halbleiterkörpers erstrecken.

7. Verfahren nach einem der vorhergehenden Ansprüche, wobei das Kollektor- und/oder Emittergebiet zumindest eines Transistors (Q11,Q12, Q13, Q21,Q22,Q23, Q31,Q32,Q33, Q41, Q42, Q43) derart hergestellt wird, dass es an das Substrat grenzt und mit einer Verbindungselektrode auf einer ersten Hauptfläche des Substrats versehen wird.

8. Verfahren nach einem der vorhergehenden Ansprüche, wobei die vierte Halbleiterregion (4) und die fünfte Halbleiterregion (5) voneinander lateral beabstandet hergestellt werden.

9. Verfahren nach einem der vorhergehenden Ansprüche, wobei die vierte Halbleiterregion (4) und die fünfte Halbleiterregion (5) voneinander durch einen Isolator isoliert werden.

10. **Halbleiteranordnung** von mindestens drei Bipolartransistoren (Q11, Q12, Q13, Q21, Q22, Q23, Q31, Q32, Q33, Q41, Q42, Q43) in einem Halbleiterkörper, deren jeweilige Basis aus einem schichtförmigen Halbleitergebiet (2, 4, 5) eines zweiten Leitungstyps gebildet ist, wobei ein schichtförmiges Zwischenbasisgebiet (3) als Halbleitergebiet eines ersten, dem zweiten Leitungstyp entgegengesetzten Leitungstyps an jedes schichtförmige Halbleitergebiet (2, 4, 5) des zweiten Leitungstyps der drei Bipolartransistoren (Q11, Q12, Q13, Q21, Q22, Q23, Q31, Q32, Q33, Q41, Q42, Q43) grenzt, mit zumindest einen Hetero-Übergang (23, 42, 53) zwischen dem schichtförmigen Zwischenbasisgebiet (3) und einem der schichtförmigen Halbleitergebiete (2, 4, 5) des ersten Leitungstyps.

11. Halbleiteranordnung nach Anspruch 10, wobei das Zwischenbasisgebiet (3) einen Kollektor mindestens eines Bipolartransistors (Q33, Q43) und Emitter zumindest zweier Bipolartransistoren (Q31, Q32, Q41, Q42) bildet. ,

12. Halbleiteranordnung nach Anspruch 10, wobei das Zwischenbasisgebiet (3) einen Emitter mindestens eines Bipolartransistors (Q13, Q23) und Kollektoren zumindest zweier Bipolartransistoren (Q11, Q12, Q21, Q22) bildet.

13. Halbleiteranordnung nach einem der Ansprüche 10 bis 12, wobei das Zwischenbasisgebiet (3) homogen dotiert ist.

14. Halbleiteranordnung nach einem der Ansprüche 10 bis 13, wobei das Zwischenbasisgebiet (3) einen elektrischen Kontakt aufweist.

15. Halbleiteranordnung nach einem der Ansprüche 10 bis 14, wobei das Zwischenbasisgebiet (3) eine Dotierstoffkon-zentration von mindestens $1 \cdot 10^{17}$ cm$^{-3}$ vorzugswei-se mehr als $5 \cdot 10^{17}$ cm$^{-3}$ aufweist.

16. Halbleiteranordnung nach einem der Ansprüche 10 bis 15, wobei das schichtförmige Zwischenbasisgebiet (3) eine Dicke von weniger als 200nm, vorzugsweise von weniger als 100nm aufweist.

17. **Mehrschlchtbauelement** mit

- Halbleiterschichten (1,3,6, 7) eines ersten Leitungstyps und
- Halbleiterschichten (2, 4, 5) eines zweiten, dem ersten Leitungstyp entgegengesetzten Leitungstyps, die zumindest drei Transistoren (Q11,Q12,Q13, Q21,Q22,Q23, Q31,Q32, Q33, Q41,Q42,Q43) bilden, wobei - Halbleiterschichten (2, 4, 5) des zweiten Lei-tungstyps die Basen ($B_{11}$, ..., $B_{43}$) der Transi-storen (Q11, Q12, Q13, Q21, Q22, Q23, Q31, Q32, Q33, Q41, Q42, Q43) und - Halbleiterschichten (1, 3, 6, 7) des ersten Leitungstyps neben zumindest einem Kollektor

($C_{13}$, $C_{23}$, $C_{31}$, $C_{32}$, $C_{41}$, $C_{42}$) und zumindest einem Emitter ($E_{11}$, $E_{12}$, $E_{21}$, $E_{22}$, $E_{33}$, $E_{43}$) eine Zwischenbasisschicht (3) bilden,

wobei

- die Zwischenbasisschicht (3) an die Halbleiterschichten (2, 4, 5) des zweiten Leitungstyps grenzt,
- die Zwischenbasisschicht (3) aus einem ersten Halbleitermaterial und
- zumindest eine Halbleiterschicht (2, 4, 5) des zweiten Leitungstyps aus einem zweiten Halbleitermaterial besteht, und
- der Wert der Energielücke in dem zweiten Halbleitermaterial um mindestens die mittlere thermische Energie der Ladungsträger kleiner ist, als der Wert der Energielücke in dem ersten Halbleitermaterial.

18. Mehrschichtbauelement nach Anspruch 17, wobei die Halbleiterschichten (1, 2, 3, 4, 5, 6, 7) des ersten und zweiten Leitungstyps im Wesentlichen parallel zu einer Hauptfläche des Halbleiterkörpers angeordnet sind.

19. Mehrschichtbauelement nach einem der vorhergehenden Ansprüche, wobei alle in dem Halbleiterkörper kontaktierten Halbleiterschichten (1, 2, 3, 4, 5, 6, 7) des ersten und zweiten Leitungstyps zur Vorderseite des Halbleiterkörpers kontaktiert werden.

**Claims**

1. Method for integration of three bipolar transistors (Q11, Q12, Q13, Q21, Q22, Q23, Q31, Q32, Q33, Q41, Q42, Q43) in one semiconductor body, in that

- a first layer-shaped semiconductor region (1) of a first conductivity type is produced,
- a second layer-shaped semiconductor region (2) of a second conductivity type, which is opposite to the first conductivity type and which adjoins the first semiconductor region (1), is produced,
- a third layer-shaped semiconductor region (3) of the first conductivity type, which adjoins the second semiconductor region (2), is produced,
- a fourth layer-shaped semiconductor region (4) and a fifth layer-shaped semiconductor region (5) of the second conductivity type, which adjoin the third semiconductor region (3), are produced, wherein the second layer-shaped semiconductor region (2), the fourth layer-shaped semiconductor region (4) and the fifth layer-shaped semiconductor region (5) form the bases of the three bipolar transistors (Q11, Q12, Q13, Q21, Q22, Q23, Q31, Q32, Q33, Q41, Q42, Q43),

- a sixth layer-shaped semiconductor region (6) and a seventh layer-shaped semiconductor region (7) of the first semiconductor type are produced, wherein the sixth semiconductor region (6) adjoins the fourth semiconductor region (4) and the seventh semiconductor region (7) adjoins the fifth semiconductor region (5),

- the second semiconductor region (2) and/or the fourth semiconductor region (4) and/or the fifth semiconductor region (5) are made from a first semiconductor material and

- the third semiconductor region (3) is made from a second semiconductor material,

wherein the first semiconductor material and the second semiconductor material are produced in such a manner that

- the value of the energy gap in the first semiconductor material is smaller than the value of the energy gap in the second semiconductor material by at least the mean thermal energy of the charge carrier.

2. Method according to claim 1, wherein for producing the third semiconductor region (3) this is doped homogenously.

3. Method according to one of the preceding claims, wherein at least two of the three transistors (Q11, Q12, Q13, Q21, Q22, Q23, Q31, Q32, Q33. Q41, Q42, Q43) are integrated vertically.

4. Method according to any one of the preceding claims, wherein $Si_{1-x}Ge_x$ is used as first semiconductor material and Si is used as second semiconductor material.

5. Method according to any one of the preceding claims, wherein the second semiconductor region (2) is made from the first semiconductor material and the fourth semiconductor region (4) and fifth semiconductor region (5) are made from a third semiconductor material.

6. Method according to any one of the preceding claims, wherein transitions between the semiconductor regions (1, 2, 3, 4, 5, 6, 7) extend substantially parallel to a main surface of the semiconductor body.

7. Method according to any one of the preceding claims, wherein the collector area and/or emitter area of at least one transistor (Q11, Q12, Q13, Q21, Q22, Q23, Q31, Q32, Q33, Q41, Q42, Q43) is or are produced in such a manner that it adjoins the substrate and is provided with a connecting electrode on a first main surface of the substrate.

8. Method according to any one of the preceding claims, wherein the fourth semiconductor region (4) and the fifth semiconductor region (5) are produced to be laterally spaced from one another.

9. Method according to any one of the preceding claims, wherein the fourth semiconductor region (4) and the fifth semiconductor region (5) are insulated from one another by an insulator.

10. Semiconductor arrangement of at least three bipolar transistors (Q11, Q12, Q13, Q21, Q22. Q23, Q31, Q32, Q33, Q41, Q42, Q43) in a semiconductor body, the respective base of which is formed from a layer-shaped semiconductor region (2, 4, 5) of a second conductivity type, wherein a layer-shaped intermediate base region (3) as semiconductor region of a first conductivity type, which is opposite to the second conductivity type, adjoins each layer-shaped semiconductor region (2, 4, 5) of the second semiconductor type of the three bipolar transistors (Q11, Q12, Q13, Q21, Q22, Q23, Q31, Q32, Q33, Q41, Q42, Q43), with at least hetero-transition (23, 42, 53) between the layer-shaped intermediate base region (3) and one of the layer-shaped semiconductor regions (2, 4, 5) of the first conductivity type.

11. Semiconductor arrangement according to claim 10, wherein the intermediate base region (3) forms a collector of at least one bipolar transistor (Q33, Q43) and emitters of at least two bipolar transistors (Q31, Q32, Q41, Q42).

12. Semiconductor arrangement according to claim 10, wherein the intermediate base region (3) forms an emitter of at least one bipolar transistor (Q13, Q23) and collectors of at least two bipolar transistors (Q11, Q12, Q21, Q22).

13. Semiconductor arrangement according to any one of claims 10 to 12, wherein the intermediate base region (3) is doped homogenously.

14. Semiconductor arrangement according to any one of claims 10 to 13, wherein the intermediate base region (3) has an electrical contact.

15. Semiconductor arrangement according to any one of claims 10 to 14, wherein the intermediate base region (3) has a doping material concentration of at least $1 \cdot 10^{-17} \text{ cm}^{-3}$, preferably more than $5 \cdot 10^{17} \text{ cm}^{-3}$

16. Semiconductor arrangement according to any one of claims 10 to 15, wherein the layer-shaped intermediate base region (3) has a thickness of less than 200 nm, preferably less than 100 nm.

**17.** Multi-layer component with

- semiconductor layers (1, 3, 6, 7) of a first conductivity type and
- semiconductor layers (2, 4, 5) of a second conductivity type opposite to the first conductivity type,

which form at least three transistors (Q11, Q12, Q13, Q21, Q22, Q23, Q31, Q32, Q33, Q41, Q42, Q43), wherein

- semiconductor layers (2, 4, 5) of the second conductivity type form the bases ($B_{11}$, ..., $B_{43}$) of the transistors (Q11, Q12, Q13, Q21, Q22, Q23, Q31, Q32, Q33, Q41, Q42, Q43) and
- semiconductor layers (1, 3, 6, 7) of the first conductivity type form, apart from at least on a collector ($C_{13}$, $C_{23}$, $C_{31}$, $C_{32}$, $C_{41}$, $C_{42}$) and at least one emitter ($E_{11}$, $E_{12}$, $E_{21}$, $E_{22}$, $E_{33}$, $E_{43}$), an intermediate base layer (3),

wherein

- the intermediate base layer (3) adjoins the semiconductor layers (2, 4, 5) of the second conductivity type,
- the intermediate base layer (3) consists of a first semiconductor material and
- at least one semiconductor layer (2, 4, 5) of the second conductivity type consists of a second semiconductor material and
- the value of the energy gap in the second semiconductor material is smaller than the value of the energy gap in the first semiconductor material by at least the mean thermal energy of the charge carrier.

**18.** Multi-layer component according to claim 17, wherein the semiconductor layers (1, 2, 3, 4, 5, 6, 7) of the first and second conductivity type are arranged substantially parallel to a main surface of the semiconductor body.

**19.** Multi-layer component according to any one of the preceding claims, wherein all semiconductor layers (1, 2, 3, 4, 5, 6, 7), which are contacted in the semiconductor body, of the first and second conductivity type are contacted towards the front side of the semiconductor body.

**Revendications**

**1.** Procédé d'intégration de trois transistors bipolaires (Q11, Q12, Q13, Q21, Q22, Q23, Q31, Q32, Q33, Q41, Q42, Q43) dans un corps semi-conducteur, consistant en ce que :

- l'on forme une première zone semi-conductrice (1) selon une couche d'un premier type de conduction,
- l'on forme une deuxième zone semi-conductrice (2) selon une couche d'un deuxième type de conduction opposé au premier, contiguë à la première zone semi-conductrice (1),
- l'on forme une troisième zone semi-conductrice (3) selon une couche du premier type de conduction, contiguë à la deuxième zone semi-conductrice (2),
- l'on forme une quatrième zone semi-condutrice (4) selon une couche et une cinquième zone semi-conductrice (5) selon une couche du deuxième type de conduction, contiguës à la troisième zone semi-conductrice (3), la deuxième zone semi-conductrice (2) selon une couche, la quatrième zone semi-conductrice (4) selon une couche et la cinquième zone semi-conductrice (5) selon une couche constituant les bases des trois transistors bipolaires (Q11, Q12, Q13, Q21, Q22, Q23, Q31, Q32, Q33, Q41, Q42, Q43),
- l'on forme une sixième zone semi-conductrice (6) selon une couche et une septième zone semi-conductrice (7) selon une couche du premier type de conduction, la sixième zone semi-conductrice (6) étant contiguë à la quatrième zone semi-conductrice (4) et la septième zone semi-conductrice (7), à la cinquième zone semi-conductrice (5),
- l'on réalise la deuxième zone semi-conductrice (2) et/ou la quatrième zone semi-conductrice (4) et/ou la cinquième zone semi-conductrice (5) dans un premier matériau semi-conducteur, et
- l'on réalise la troisième zone semi-conductrice (3) dans un deuxième matériau semi-conducteur, le premier matériau semi-conducteur et le deuxième matériau semi-conducteur étant fabriqués de telle façon que
- la valeur de la lacune énergétique dans le premier matériau semi-conducteur est inférieure d'au moins l'énergie thermique moyenne des porteurs de charge à la valeur de la lacune énergétique dans le deuxième matériau semi-conducteur.

**2.** Procédé selon la revendication 1, dans lequel, pour produire la troisième zone semi-conductrice (3), on la dope de manière homogène.

**3.** Procédé selon l'une quelconque des revendications précédentes, dans lequel on intègre de manière verticale au moins deux parmi les trois transistors (Q11, Q12, Q13, Q21, Q22, Q23, Q31, Q32, Q33, Q41, Q42, Q43).

**4.** Procédé selon l'une quelconque des revendications précédentes, dans lequel on utilise comme premier matériau semi-conducteur du $Si_{1-x}Ge_x$ et comme deuxième matériau semi-conducteur du Si.

5. Procédé selon l'une quelconque des revendications précédentes, dans lequel on réalise la deuxième zone semi-conductrice (2) dans un premier matériau semi-conducteur et les quatrième (4) et cinquième (5) zones semi-conductrices dans un troisième matériau semi-conducteur.

6. Procédé selon l'une quelconque des revendications précédentes, dans lequel des jonctions entre les zones semi-conductrices (1, 2, 3, 4, 5, 6, 7) s'étendent sensiblement parallèles à une surface principale du corps semi-conducteur.

7. Procédé selon l'une quelconque des revendications précédentes, dans lequel la zone collectrice et/ou émettrice d'au moins un transistor (Q11, Q12, Q13, Q21, Q22, Q23, Q31, Q32, Q33, Q41, Q42, Q43) est formée de façon à être contiguë au substrat et pourvue d'une électrode de liaison sur une surface principale du substrat.

8. Procédé selon l'une quelconque des revendications précédentes, dans lequel la quatrième zone semi-conductrice (4) et la cinquième zone semi-conductrice (5) sont formées latéralement à distance l'une de l'autre.

9. Procédé selon l'une quelconque des revendications précédentes, dans lequel la quatrième zone semi-conductrice (4) et la cinquième zone semi-conductrice (5) sont isolées l'une de l'autre par un isolateur.

10. Arrangement semi-conducteur d'au moins trois transistors bipolaires (Q11, Q12, Q13, Q21, Q22, Q23, Q31, Q32, Q33, Q41, Q42, Q43) dans un corps semi-conducteur, dont la base est formée d'une zone semi-conductrice (2, 4, 5) selon une couche d'un deuxième type de conduction, une zone inter-bases (3) selon une couche étant contiguë, comme zone semi-conductrice d'un premier type de conduction opposé au deuxième type, à chaque zone semi-conductrice (2, 4, 5) sous forme de couche du deuxième type de conduction des trois transistors bipolaires (Q11, Q12, Q13, Q21, Q22, Q23, Q31, Q32, Q33, Q41, Q42, Q43), comprenant au moins une hétérojonction (23, 42, 53) entre la zone inter-bases (3) en couche et une des zones semi-conductrices (2, 4, 5) du premier type de conduction.

11. Arrangement semi-conducteur selon la revendication 10, dans lequel la zone inter-bases (3) constitue un collecteur d'au moins un transistor bipolaire (Q33, Q43) et l'émetteur d'au moins deux transistors bipolaires (Q31, Q32, Q41; Q42).

12. Arrangement semi-conducteur selon la revendication 10, dans lequel la zone inter-bases (3) constitue un émetteur d'au moins un transistor bipolaire (Q13, Q23) et les collecteurs d'au moins deux transistors bipolaires (Q11, Q12, Q21, Q22).

13. Arrangement semi-conducteur selon l'une quelconque des revendications 10 à 12, dans lequel la zone inter-bases (3) est dopée de manière homogène.

14. Arrangement semi-conducteur selon l'une quelconque des revendications 10 à 13, dans lequel la zone inter-bases (3) présente un contact électrique.

15. Arrangement semi-conducteur selon l'une quelconque des revendications 10 à 14, dans lequel la zone inter-bases (3) présente une concentration en produits dopants d'au moins $1 \cdot 10^{17}$ cm$^{-3}$, de préférence supérieure à $5 \cdot 10''$ cm$^{-3}$.

16. Arrangement semi-conducteur selon l'une quelconque des revendications 10 à 15, dans lequel la zone inter-bases (3) selon une couche présente une épaisseur inférieur à 200nm, de préférence inférieure à 100 nm.

17. Composant multicouches comprenant

- des couches semi-conductrices (1, 3, 6, 7) d'un premier type de conduction, et
- des couches semi-conductrices (2, 4, 5) d'un deuxième type de conduction opposé au premier,
qui composent au moins trois transistors (Q11, Q12, Q13, Q21, Q22, Q23, Q31, Q32, Q33, Q41, Q42, Q43), dans lequel
- des couches semi-conductrices (2, 4, 5) du deuxième type de conduction constituent les bases ($B_{11}$, ..., $B_{43}$) des transistors (Q11, Q12, Q13, Q21, Q22, Q23, Q31, Q32, Q33, Q41, Q42, Q43), et
- des couches semi-conductrices (1, 3, 6, 7) du premier type de conduction constituent une couche inter-bases (3) à côté d'au moins un collecteur ($C_{13}$, $C_{23P}$ $C_{31}$, $C3_2$, $C_{41}$, $C_{42}$) et d'au moins un émetteur ($E_{11}$, $E_{12}$, $E_{21}$,3 $E_{22}$, $E_{33}$, $E_{43}$), dans lequel
- la couche inter-bases (3) est contiguë aux couches semi-conductrices (2, 4, 5) du deuxième type de conduction,
- la couche inter-bases (3) est constituée d'un premier matériau semi-conducteur,
- et au moins une couche semi-conductrice (2, 4, 5) du deuxième type de conduction est constituée d'un deuxième matériau semi-conducteur, et
- la valeur de la lacune énergétique dans le deuxième matériau semi-conducteur est inférieure d'au moins l'énergie thermique moyenne des porteurs de charge à la valeur de la lacune énergétique dans le premier matériau semi-conducteur.

**18.** Composant multicouches selon la revendication 17, dans lequel les couches semi-conductrices (1, 2, 3, 4, 5, 6, 7) du premier et du deuxième type de conduction sont disposées sensiblement parallèles à une surface principale du corps semi-conducteur.

**19.** Composant multicouches selon l'une quelconque des revendications précédentes, dans lequel toutes les couches semi-conductrices (1, 2, 3, 4, 5, 6, 7) du premier et du deuxième type de conduction en contact dans le corps semi-conducteur sont mises en contact avec la face avant du corps semi-conducteur.

FIG. 1

FIG. 2

FIG. 3

FIG. 4

FIG.1a

43 →          ← 53

          ← 23

FIG.1b

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 0493854 A
- EP 605920 A
- US 4771013 A
- DE 3743774 A1